# EUROPEAN PATENT APPLICATION

(11) **EP 1 001 466 A1**
(43) Date of publication of application: **17.05.2000**
(21) Application number: 98830675.9
(22) Date of filing: 10.11.1998
(51) Int. Cl.: H01L 27/105, H01L 27/088, H01L 21/8234

(54) **High-voltage transistor structure for handling high-voltages in CMOS integrated circuits**

(71) Applicant: STMicroelectronics S.r.l., 20041 Agrate Brianza (Milano) (IT)
(72) Inventor: Riva, Carlo, 20055 Renate (MI) (IT); Ghezzi, Paolo, 26027 Rivolta d'Adda (CR) (IT); Maurelli, Alfonso, 20050 Sulbiate (MI) (IT)
(74) Representative: Mittler, Enrico

(57) **Abstract**

High-voltage transistor structure, particularly for handling programming and/or programming and erasing voltages for electrically programmable and/or electrically programmable and erasable non-volatile memory cells which are integrated together with the high-voltage transistor and a low-voltage logic circuitry in a same semiconductor chip, the logic circuitry comprising first conductivity type channel transistors and second conductivity type channel transistors respectively formed inside second conductivity type wells (2) and first conductivity type wells (3), the first and second conductivity type wells (2,3) formed in a common substrate (1) of the first conductivity type which forms a common substrate of the semiconductor chip, the high-voltage transistor comprising an insulated gate electrode (10) and source and drain electrodes (9) at the sides of the insulated gate electrode (10). The insulated gate electrode (10) is insulated from the underlying common substrate (1) of the first conductivity type by a portion of a thick field oxide (4), and the source and drain electrodes (9) are doped regions of a second conductivity type formed directly in said common substrate (1).

## Description

The present invention relates to CMOS integrated circuits. In particular the invention concerns CMOS integrated circuits including electrically programmable and/or electrically programmable and erasable non-volatile memory elements, such as EPROM, Flash EEPROM, EEPROM memory cells. Such memory cells require relatively high voltages for their programming and/or erasing. CMOS integrated circuits of this kind include for example stand-alone EPROM, EEPROM or Flash EEPROM memory chips, or microcontroller chips with embedded memories.

In integrated circuits including electrically programmable and/or electrically programmable and erasable non-volatile programmable memory cells, either stand-alone memory device chips or microcontroller chips with embedded memory devices, it is always necessary to internally handle the relatively high voltages for programming and/or erasing the memory cells.

Generally, the voltages required for programming and/or erasing the memory cells are higher than the operating voltages of the logic circuitry. This holds true whichever the type of non-volatile memory cell, and whichever the programming and/or erasing mechanisms involved. For example, the last generations of CMOS integrated circuits work at 3.3 V, while programming and erasing of the memory cells require voltages of approximately 10 V or more.

The evolution of integrated devices' manufacturing technologies and the trend towards higher speed and lower power consumption allows to forecast further reductions of the operating voltages for CMOS logic circuits. On the contrary, the voltages required for programming and erasing non-volatile memory cells are not expected to significantly decrease, since the programming and erasing mechanisms require in general higher voltages.

For these reasons, in integrated circuits containing electrically programmable and/or electrically programmable and erasable non-volatile memory cells it is necessary to have, in the same chip, a standard logic circuitry working at low voltages and high speed, and a programming and/or programming/erasing circuitry for the memory cells working at higher voltages. This is especially true in the case of purely logic integrated circuits with embedded non-volatile memories, such as microcontrollers, wherein the speed and voltage requirements are much more aggressive than in conventional stand-alone memory chips.

In all these cases it is necessary to design and integrate in the chip transistors capable of withstanding relatively high voltages with a sufficient degree of reliability and without affecting the performance of the low-voltage logic circuitry.

Such transistors, in order to be capable of sustaining the high programming and erasing voltages, have to comply with some basic requirements which impose dedicated technological solutions. In particular:
- the breakdown voltage of the gate oxide of these transistors must be higher than the operating voltage thereof. To this purpose, transistors which have to sustain the programming and erasing voltages of non-volatile memory cells are designed to have a gate oxide thicker than the gate oxide of the transistors of the low-voltage logic circuitry. This involves an additional masking and etching step, and an additional oxide growth compared to the standard manufacturing process;
- the transistors must be reliable in terms of source and drain junction breakdown, leakage current and punch-through effect (source to drain short-circuit due to the depletion of the junctions under the transistor's gate when the high voltage for programming and erasing of the memory cells is applied to the source or the drain of the transistor). To satisfy these requirements, the manufacturing of these transistors provides for dedicated implants suitable for regulating the threshold voltage and preventing punch-through. These implants are different from those which can be correspondingly provided for low-voltage logic circuit transistors, so further additional process steps are required.

It appears that the conventional way of forming high-voltage transistors requires two additional masks, one additional oxide growth, and one or more additional dopant implants.

In view of the state of the art described, it has been an object of the present invention to provide a new transistor structure for handling the relatively high voltages required for programming and erasing electrically programmable and erasable non-volatile memory cells, said transistor structure being easily integratable in integrated circuits including a standard low-voltage logic circuitry and non-volatile memory cells with a minimum modification to the standard process flow and possibly without any additional process step.

According to the present invention, such an object has been achieved by means of a high-voltage transistor structure, particularly for handling programming and/or programming and erasing voltages for electrically programmable and/or electrically programmable and erasable non-volatile memory cells which are integrated together with the high-voltage transistor and a low-voltage logic circuitry in a same semiconductor chip, the logic circuitry comprising first conductivity type channel transistors and second conductivity type channel transistors respectively formed inside second conductivity type wells and first conductivity type wells, the first and second conductivity type wells formed in a common substrate of the first conductivity type which forms a common substrate of the semiconductor chip, the high-voltage transistor comprising an insulated gate electrode and source and drain electrodes at the sides of the insulated gate electrode, characterized in that the insulated gate electrode is insulated from the underlying common substrate of the first conductivity type by a portion of a thick field oxide, and in that said source and drain electrodes are doped regions of a second conductivity type formed directly in said common substrate.

The features and advantages of the present invention will be made apparent by the following detailed description of a particular embodiment thereof, illustrated by way of a non-limiting example only in the annexed drawings, wherein:

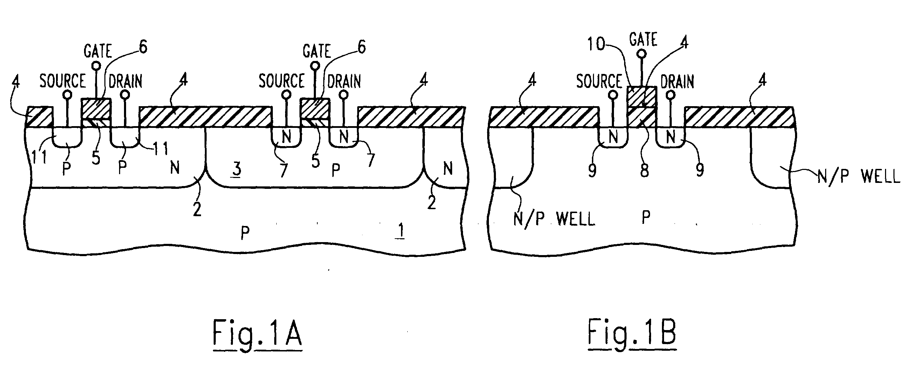

Figure 1A is a cross-sectional view of a portion of an integrated circuit wherein a transistor for a low-voltage logic circuitry is formed; and
Figure 1B is a similar cross-sectional view of another region of the integrated circuit, wherein a high-voltage transistor according to the present invention is formed.

With reference to Figures 1A and 1B, cross-sectional views of two portions of an integrated circuit are shown. More specifically, the portion shown in Fig. 1A is a portion of the integrated circuit wherein a standard low-voltage, high-speed logic circuitry is formed, while the portion shown in Fig. 1B is a portion wherein a high-voltage transistor is formed suitable for handling programming and erasing voltages for electrically programmable and/or electrically programmable and erasable non-volatile memory cells (EPROM, EEPROM, Flash EEPROM) also embedded in the integrated circuit even if not shown in the drawings.

Referring to Fig. 1A, the integrated circuit conventionally comprises a semiconductor substrate 1. In the shown and described example, substrate 1 is a P type semiconductor substrate, containing a P type dopant such as boron in a typical concentration range of 1*10¹⁵ to 5*10¹⁵ atoms/cm³, with a resistivity value in the range 2 to 10 Ohms*cm. A P type substrate is quite a common case in the art, however this is clearly not a limitation to the present invention, and an N type substrate could be suitable as well.

As the skilled reader is well aware of, it is nowadays quite usual in CMOS integrated circuits to use the so-called "twin-well" or "twin-tub" technology, which provides for forming in the substrate both N type and P type wells or tubs. With a P type substrate, N type wells are required for forming P-channel transistors. P type wells would not be strictly speaking necessary, since N-channel transistors could be formed directly in the P type substrate. However, the use of P type wells wherein to form N-channel transistors has several advantages, for example it allows to make the N-channel transistors not dependent on the dopant concentration of the substrate.

According to the above, N type wells 2 and P type wells 3 are formed in the substrate 1 by selectively introducing into the substrate N type and P type dopants, respectively. The N type wells 2 will host P-channel transistors of a low-voltage logic circuit of the integrated circuit. The P type wells 3 will host N-channel transistors of the logic circuitry, and also non-volatile memory cells which are normally N-channel devices.

One of the P-channel transistors and one of the N-channel transistors of the logic circuitry are depicted in Fig. 1A. The structure of the two transistors is totally conventional: as regards the P-channel transistor, in an active area region over the N type well the surface of which is free of thick field oxide regions 4 a gate oxide layer 5 is formed over the N type well 2; a conductive (normally polysilicon) gate electrode 6 is formed over the gate oxide layer 5. P type source and drain regions 11 are formed in the N type well at the sides of the gate electrode. Correspondingly, as regards the N-channel transistor, in an active area region over the P type well the surface of which is free of thick field oxide regions 4, a gate oxide layer 5 is formed over the P type well; a conductive (normally polysilicon) gate electrode 6 is formed over the gate oxide layer 5. N type source and drain regions 7 are formed in the P type well at the sides of the gate electrode.

The field oxide 4 is conventionally disposed between different active areas of the integrated circuit, and is used to prevent formation in the P type well or N type well of parasitic inversion layers (conductive channels) where no transistors are to be formed.

According to the present invention, a high-voltage transistor structure capable of handling the high voltages required for programming and erasing electrically programmable and/or erasable non-volatile memory cells is depicted in Fig. 1B. Differently from the transistors of the low-voltage logic circuitry such as the one depicted in Fig. 1A, the high-voltage transistor has a gate oxide 8 obtained from the thick field oxide layer 4. A conductive (polysilicon) gate 10 is disposed over the gate oxide 8. N type source and drain regions 9 are formed directly in the substrate 1 at the sides of the gate oxide 8.

The typical thickness of the gate oxide 5 of the low-voltage transistors is in the range 25-100 Å. The field oxide 4 has a thickness of the order of some thousands Angstroms, typically in the range 3000 to 6000 Å. Thanks to the substantial higher thickness of the field oxide compared to the normal gate oxide for low-voltage transistors, high voltages can be applied to the gate electrode of the high-voltage transistor without the risk of any break of its gate oxide. The voltage values normally involved in the programming and erasing of the non-volatile memory cells, ranging from 10 to 15 V, produce electric fields well below the critical value causing breaks in the field oxide. Having a gate oxide as thick as the field oxide determines an increase of the threshold voltage of the transistor. As known, the threshold voltage of a MOS transistor is directly proportional to the thickness of the gate oxide. However, still according to the invention, the high-voltage transistor is not formed inside a P type well as the N-channel transistors of the low-voltage circuitry: the high voltage transistor is instead formed directly in the substrate 1. Since the substrate 1 has a lower dopant concentration than the P type well, the result of forming the high-voltage transistor directly in the substrate instead that in a P type well is a lowering of the threshold voltage, so that even if the gate oxide of the high-voltage transistor is as thick as the field oxide a suitable threshold voltage is obtained. By way of example, with a substrate having a resistivity of 2 to 10 Ohms*cm and a field oxide of thickness ranging from 3000 to 6000 Å, a threshold voltage of approximately 0.5 - 1.5 V is obtained, fully compatible with the operating voltages encountered in standard integrated circuits.

In order to form a high-voltage transistor according to the invention, the only modification required to the standard manufacturing process is a change in the layout of the photolithographic mask already provided for the selective formation of the P type wells in the substrate. More specifically, the mask which in the standard process is used to prevent the introduction into the substrate of P type dopants in regions where the N type wells are to be formed is modified so to cover also those regions of the substrate where the high-voltage transistors are to be formed. Since this same mask is also conventionally used for the threshold voltage adjustment and anti-punch-through implants of the low-voltage logic transistors, the above modification to the layout of this mask allows for forming the high-voltage transistors directly in the substrate. No additional photolithographic mask nor additional process steps are required in order to form the high-voltage transistor according to this invention.

The advantages with respect to prior-art techniques for forming high-voltage transistors are clear: no additional oxide etching and thermal oxidation steps are required for forming gate oxides thicker than the gate oxide of the transistors in the low-voltage logic circuitry, nor are dedicated selective implants of dopants for adjusting the threshold voltage of the high-voltage transistors.

In case of different (lower) substrate resistivity, not able to provide the desired threshold voltage for the high-voltage transistor, it can be also foreseen a blanket (i.e., without mask) implant performed for example before the formation of the N type and P type wells, so to obtain the needed dopant concentration below the thick gate oxide 8 of the high-voltage transistor. That means we can obtain high-voltage transistors with the same electrical performance whichever the resistivity of the starting substrate, just be means of an extra process step (one implant, no mask). This extra implant would only modify the resistivity of the substrate in a surface layer thereof The standard twin-tub dopant implants should in this case be slightly modified as far as the dopant doses are concerned in order to compensate the change in resistivity of the substrate at the surface thereof

## Claims

1. High-voltage transistor structure, particularly for handling programming and/or programming and erasing voltages for electrically programmable and/or electrically programmable and erasable non-volatile memory cells which are integrated together with the high-voltage transistor and a low-voltage logic circuitry in a same semiconductor chip, the logic circuitry comprising first conductivity type channel transistors and second conductivity type channel transistors respectively formed inside second conductivity type wells (2) and first conductivity type wells (3), the first and second conductivity type wells (2,3) formed in a common substrate (1) of the first conductivity type which forms a common substrate of the semiconductor chip, the high-voltage transistor comprising an insulated gate electrode (10) and source and drain electrodes (9) at the sides of the insulated gate electrode (10), characterized in that the insulated gate electrode (10) is insulated from the underlying common substrate (1) of the first conductivity type by a portion of a thick field oxide (4), and in that said source and drain electrodes (9) are doped regions of a second conductivity type formed directly in said common substrate (1).

2. High-voltage transistor structure according to claim 1, characterized in that said thick field oxide (4) has a thickness of the order of some thousands of Angstroms.

3. High-voltage transistor according to claim 2, characterized in that said thick field oxide (4) has a thickness in the range 3000 to 6000 Angstroms.

4. High-voltage transistor according to claim 2, characterized in that said semiconductor substrate has a resistivity ranging from 2 to 10 Ohms*cm, at least at a surface thereof.

5. High-voltage transistor according to claim 4, characterized in that said substrate has a substantially constant resistivity throughout its thickness.

6. High-voltage transistor according to claim 4, characterized in that said substrate has a first resistivity at a surface thereof, and a second resistivity in the remaining of the thickness thereof.

7. High-voltage transistor according to anyone of the preceding claims, characterized in that said first conductivity type is P and said second conductivity type is N.

8. High-voltage transistor according to anyone of claims 1 to 6, characterized in that said first conductivity type is N and said second conductivity type is P.

9. Process for manufacturing an integrated circuit including a low-voltage logic circuitry, electrically programmable and/or electrically programmable and erasable non-volatile memory cells, and high-voltage transistors for handling programming and erasing voltages for the non-volatile memory cells, providing for forming, in a common semiconductor substrate (1) of a first conductivity type, first conductivity type and second conductivity type wells (2,3) for transistors of the logic circuitry, defining in said first and second conductivity type wells (2,3) active areas separated by thick field oxide regions (4), forming in said active areas thin gate oxides (5), gate electrodes (6) and source and drain regions (9,11) of the transistors of the logic circuitry, forming the non-volatile memory cells, and forming the high-voltage transistors, characterized in that said forming the high-voltage transistors provides for forming directly over the common substrate (1) thick field oxide portions (4) acting as gate oxides (8) of the high-voltage transistors, forming over said thick field oxide portions gate electrodes (10) of the high-voltage transistors, and forming directly in the common substrate (1) at the sides of the thick field oxide portions source and drain regions (9) of the high-voltage transistors.

10. Process according to claim 9, characterized by providing for preventing dopants forming said first and second conductivity type wells (2,3) from being implanted in the common substrate in regions thereof where the high-voltage transistors are to be formed.

11. Process according to claim 10, characterized by providing, before said forming of first and second conductivity type wells, modifying a resistivity of the substrate at the surface thereof.

12. Process according to claim 11, characterized in that said modifying the resistivity of the substrate provides for performing a blanket implant of dopants in the whole substrate surface.
